(19) Europäisches Patentamt
European Patent Office
Office européen des brevets

(11) Numéro de publication: **0 143 030**
**B1**

(12) # FASCICULE DE BREVET EUROPÉEN

(45) Date de publication du fascicule du brevet: **25.01.89**

(51) Int. Cl.⁴: **H 04 N 3/15**

(21) Numéro de dépôt: **84402075.0**

(22) Date de dépôt: **16.10.84**

(54) **Procédé d'analyse d'un dispositif photosensible à structure interligne, et dispositif pour sa mise en oeuvre.**

(30) Priorité: **21.10.83 FR 8316792**

(43) Date de publication de la demande: **29.05.85 Bulletin 85/22**

(45) Mention de la délivrance du brevet: **25.01.89 Bulletin 89/4**

(84) Etats contractants désignés: **DE GB NL**

(56) Documents cité:
**EP-A-0 078 038**

**ELECTRONIC DESIGN, vol. 29, no. 16, août 1981, pages 183-190, Waseca, MN, US; A.P. KING et al.: "Charge-coupled devices tackle TV imaging"**

(73) Titulaire: **THOMSON- CSF, 173, Boulevard Haussmann, F-75379 Paris Cédex 08 (FR)**

(72) Inventeur: **Berger, Jean- Luc, THOMSON- CSF SCPI 173, bld Haussmann, F-75379 Paris Cedex 08 (FR)**

(74) Mandataire: **Ruellan- Lemonnier, Brigitte, THOMSON- CSF SCPI 19, avenue de Messine, F-75008 Paris (FR)**

**EP 0 143 030 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1989

## Description

La présente invention concerne un procédé d'analyse d'un dispositif à structure interligne. Elle concerne aussi un dispositif pour la mise en oeuvre dudit procédé.

Les dispositifs photosensibles à structure interligne sont bien connus de l'homme de l'art. Ils sont décrits en particulier dans l'ouvrage de C.H. SEQUIN et M.F. TOMPSETT intitulé "Charge Transfert Devices" pages 152 à 166.

Comme représenté sur les figures 1 et 2(a) de la présente demande, un dispositif photosensible à structure interligne est constitué essentiellement par une matrice photosensible 1 comportant N colonnes de M points photosensibles P, des registres à décalage analogiques 2 prévus entre chaque colonne de points photosensibles et un registre de lecture 3.

De manière plus détaillée, les M points photosensibles d'une colonne sont connectés aux M étages d'un registre analogique 2 constitué, de préférence, par un registre à transfert de charge de type CCD à entrées parallèles et sortie série, par l'intermédiaire d'une barrière de potentiel. Divers moyens peuvent être utilisés pour réaliser cette barrière de potentiel. Ainsi, comme représenté sur la figure 2(a), le registre CCD 2 est du type transfert en volume, c'est- à-dire que le canal de transfert des charges du registre 2 a reçu une implantation d'impuretés de type opposé à celui du substrat pour réaliser un canal enterré TV, par exemple une implantation d'impuretés N pour un substrat en silicium de type P. Le canal de transfert TV est séparé ces points photosensibles P constitués par des photodiodes dans le mode de réalisation représenté, par une zone 4 de transfert en surface, à savoir une zone sans dopage, le canal et ladite zone 4 de transfert en surface étant tous deux recouverts par les électrodes de stockage ES du registre CCD. De ce fait, on obtient entre les photodiodes P et le registre 2, une barrière de potentiel dont le niveau varie en fonction de la tension appliquée sur les électrodes ES. La barrière de potentiel peut aussi être réalisée à l'aide d'une grille supplémentaire prévue entre les photodiodes P et le registre 2 qui, dans ce cas, peut être du type transfert en surface ou transfert en volume.

La sortie des différents registres 2 est envoyée, par l'intermediaire d'une grille de passage $G_P$ dans un registre de lecture 3 positionné perpendiculairement aux registres 2. Le registre 3 est en général constitué par un registre à décalage analogique qui fournit l'information reçue en parallèle en mode série ce registre est de préférence un registre à transfert de charge de type CCD.

D'autre part, les différentes colonnes sont séparées les unes des autres par une barrière d'isolement 5 réalisée par une surepaisseur d'oxyde dans le mode de réalisation représenté à la figure 2(a).

Les différentes opérations d'intégration de l'image au niveau de la matrice photosensible 1 puis de lecture des charges correspondant à cette image pour obtenir en sortie du registre 3 le signal vidéo d'analyse de l'image optique reçue sur la zone photosensible sont réalisées de la manière suivante.

Pendant le temps trame dont la durée est en général de 20 millisecondes, les charges signal $Q_S$ sont intégrées dans les points photosensibles P. Ensuite, les charges signal $Q_S$ stockées dans les différents points photosensibles sont transférées dans les registres CCD 2 correspondants. Pour cela, on applique sur les électrodes ES des registres 2, un potentiel $\varnothing_{CCD}$ élevé de manière à obtenir le profil de potentiel référencé A sur la figure 2(b), ce qui élimine la barrière de potentiel entre les points photosensibles P et les registres 2 correspondants. Une fois le transfert terminé, on applique sur les registres 2 des phases de commande $\varnothing_{CCD}$ constituées par des tensions en créneaux qui donnent successivement les profils de potentiel référencés B et C. On reforme ainsi la barrière de potentiel entre les points photosensibles et les registres 2 ce qui permet une nouvelle intégration de charges signal dans les photodiodes. Pendant ce temps, les registres 2 réalisent le décalage des charges contenues dans chaque étage vers le registre de lecture 3 qui transfert lesdites charges vers un étage de lecture entre chaque transfert en provenance des registres 2.

Toutefois, avec ce mode de fonctionnement, on observe un phénomène de rémanence important dû au fait que le transfert des charges signal des photodiodes vers les registres 2 se termine en faible inversion comme cela sera expliqué de manière détaillée avec référence à la figure 3.

La figure 3 est une courbe de transfert de la charge signal $Q_S$ stockée dans une photodiode P vers le registre CCD 2 correspondant. Elle traduit l'évolution de cette charge en fonction du tempe cette courbe comporte une partie sensiblement verticale correspondant à un transfert en forte inversion, puis un coude et enfin une partie sensiblement horizontale correspondant à un transfert en faible inversion.

On suppose avoir intégré une quantité de charges $Q_S$ dans une photodiode P. On se trouve donc sur la caractéristique Q(t) de la figure 3 au point (1) du fait de la charge résiduelle $Q_r$ restant dans la photodiode. Comme la capacité de la photodiode est très faible, le point (1) se trouve positionné dans la zone de forte inversion. Après le temps de lecture TL la charge $Q_S$ a été transférée dans le registre 2. Le point de fonctionnement de la photodiode se trouve au point (2) de la caractéristique, c'est-à-dire dans le coude de la caractéristique, et la photodiode ne renferme plus que la charge résiduelle $Q_r$. Dans ce cas le transfert de la charge signal $Q_S$ a été efficace car il s'est effectué en forte inversion. Lors de la trame suivante, si l'objet lumineux ne s'est pas déplacé, une nouvelle charge $Q_S$ a été

intégrée dans la photodiode. Elle est de nouveau transférée et la charge de la photodiode évolue ainsi entre les deux points d'équilibre (1) et (2).

Toutefois, si l'objet lumineux s'est déplacé et si la photodiode considérée ne reçoit plus d'information lumineuse, à la lecture de la trame suivante effectuée en un temps TL, la charge de la photodiode évolue du point (2) vers le point (3). Il en résulte donc une lecture d'informations parasites $Q'_S$. Si l'absence d'éclairement se poursuit, on observe alors une évolution du point (3) vers le point (4) avec la lecture d'une charge parasite $Q''_5$ et ainsi de suite jusqu'à ce que le courant de faible inversion soit équilibré par le courant d'obscurité de la photodiode. La lecture des charges $Q'_S$, $Q''_S$.. constitue donc le phénomène de rémanence. Ce phénomène est particulièrement génant à bas niveau de lumière, car dans ce cas les charges $Q'_S$, $Q''_S$... ont une amplitude du même ordre de grandeur que le signal.

La présente invention a donc pour but de remédier a cet inconvénient en proposant un procédé d'analyse d'un dispositif photosensible du type interligne qui permet de réduire de façon importante le phénonmène de rémanence.

En conséquence, la présente invention a pour objet un procédé d'analyse d'un dispositif photosensible à structure interligne, ce dispositif comportant une matrice photosensible de N colonnes de M points photosensibles, chaque point photosensible d'une même colonne étant connecté à un étage d'un registre à décalage à transfert de charge qui assure le transfert des charges des points photosensibles vers un registre de lecture perpendiculaire au registre à décalage caractérisé en ce que le transfert des charges signal des points photosensibles vers les étages correspondants des registres à décalage est réalisé en superposant aux charges signal au niveau des points photosensibles une charge d'entraînement au moins suffisante pour permettre de passer en forte inversion au début du transfert.

D'autres caractéristiques et avantages de la présente invention apparaîtront à la lecture de la description d'un mode de réalisation donné à titre d'exemple non limitatif, faite avec référence aux dessins ci-annexés dans lesquels:

- la figure 1 est une vue en plan de dessus d'un dispositif photosensible à structure interligne selon l'art antérieur,
- les figures 2(a) et 2(b) sont respectivement une vue en coupe par II - II de figure 1 et un schéma expliquant son fonctionnement,
- la figure 3 est une courbe montrant comment s'effectue le transfert des charges signal des photodiodes vers les registres a décalage analogiques correspondants,
- la figure 4 est une vue en plan de dessus d'un dispositif photosensible à structure interligne conforme à la présente invention,
- les figures 5(a) et 5(b) sont respectivement une vue en coupe par Y - Y de figure 4 et un schéma expliquant son fonctionnement,
- la figure 6 est une courbe montrant comment s'effectue avec le procédé conforme à la présente invention le transfert des charges signal des photodiodes vers les registres à décalage analogiques correspondants.

Sur les différentes figures, les mêmes références désignent les mêmes éléments, mais pour des raisons de clarté les cotes et proportions des divers éléments ne sont pas respectées.

Dans l'introduction de la présente demande, on a mis en évidence que le procédé d'analyse d'un dispositif photosensible à structure interligne habituellement utilisé présente l'inconvénient d'avoir un phénomène de rémanence important dû aux charges parasites lors du passage en faible éclairement.

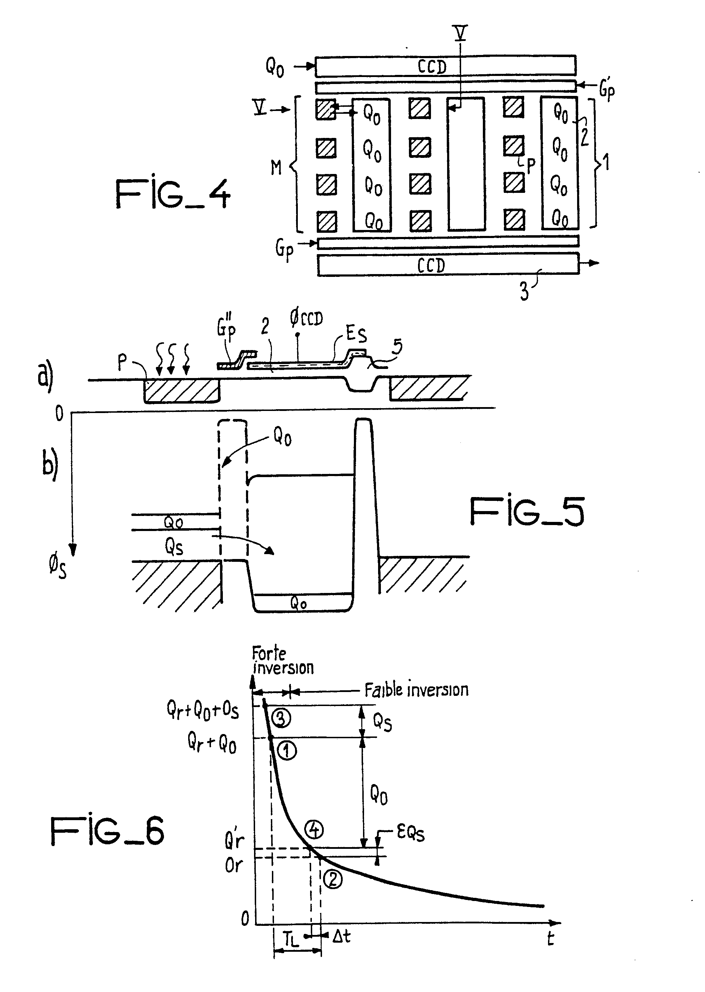

Conformément à la présente invention, on propose de résoudre ce problème en utilisant une charge d'entrainement $Q_0$ qui vient se superposer à la charge signal $Q_S$ intégrée dans les photodiodes. La figure 4 représente une vue en plan d'un dispositif photosensible à structure interligne qui a été modifié pour permettre l'injection de cette charge d'entraînement $Q_0$ sur les photodiodes conformément au procédé de la présente invention.

Comme représenté sur la figure 4, un registre analogique 6, de préference un registre à transfert de charge de type CCD, est prévu parallèlement au registre de lectur 3 mais à l'autre extrémité des registres CCD 2. Ce registre 6 à entrée série et sorties parallèles permet d'injecter la charge d'entrainement $Q_0$ vers les registres CCD 2 à travers une grille de passage $G'_P$ comme cela sera expliqué en detail ci-après.

D'autre part, comme représenté sur la figure 5(a) une grille de passage $G''_P$ est prévue entre les photodiodes P d'une même colonne et le registre CCD 2 correspondant. Dans ce cas, le registre CCD 2 peut être du type à transfert en surface ou transfert en volume.

Conformément au procédé de la présente invention, la charge $Q_0$ est injectée dans le registre CCD 6 pendant le temps de lecture du registre de lecture 3. Ensuite, lors du transfert des charges signal des registres analogiques 2 vers le registre de lecture 3, la grille de passage $G'_P$ est portée à un niveau haut et les charges $Q_0$ se trouvant au niveau de chaque sortie du registre CCD 6 sont transférées de ce registre vers le premier étage des registres 2.

Une fois réalisée la lecture des charges signal intégrées précédemment, la grille $G''_P$ est portée à un niveau haut comme représenté sur la figure 5(b) tandis que la phase $\varnothing_{CCD}$ appliquée sur les registres 2 est au niveau bas. De ce fait la charge $Q_0$ est transférée sur la photodiode P où elle vient se superposer à la charge signal $Q_S$ stockée dans cette photodiode. Ensuite la phase du registre à décalage 2 est portée au niveau haut, ce qui provoque le transfert de l'ensemble charge signal-charge d'entrainement $(Q_0 + Q_S)$ vers le

registre CCD 2.

La grille $G''_P$ est alors ramenée au niveau bas et une nouvelle intégration de charges a lieu pendant le temps de lecture des charges ($Q_0$ + $Q_S$).

On expliquera maintenant avec référence à la figure 6 comment l'utilisation d'une charge d'entraînement $Q_0$ permet de réduire l'effet de rémanence.

La caractéristique de transfert représentée à la figure 6 comporte, comme la caractéristique de transfert de la figure 3, une partie verticale correspondant à un transfert en forte inversion, une partie incurvée et une partie horizontale correspondant à un transfert en faible inversion. Lorsqu'aucune charge lumineuse n'est intégrée dans la photodiode la charge de la photodiode évolue lors de chaque transfert entre $Q_r + Q_0$ et $Q_r$ à savoir entre les points (1) et (2) sur la caractertstique de la figure 6 avec transfert à chaque trame de la charge constante $Q_0$.

Si la photodiode intègre une charge $Q_S$, au début du transfert la charge $Q_S + Q_0 + Q_r$ se trouve stockée dans la photodiode. Cette charge correspond au point (3) sur la caractéristique de la figure 6. Après un temps de transfert TL, la charge se retrouve au point (4) de la caractéristique, point qui est légèrement différent du point (2) obtenu en l'absence d'éclairement. Ce point (4) correspond à une charge résiduelle $Q'_r$.

En fait, l'erreur $(Q'_r - Q_r) = \varepsilon Q_S$ qui est lue comme rémanence à la trame suivante est proportionnelle au rapport des pentes entre les points (2) et (1). En effet, $\varepsilon Q_S$ peut aussi s'exprimer en fonction de $Q'(T_2)$ qui est la pente de la caractéristique au point (2):

$$\varepsilon Q_S = \Delta T.Q'(T_2) \qquad (1)$$

où $\Delta$ T est la projection du segment 4 - 2 sur l'axe des temps.

La projection du segment 1 - 3 sur l'axe des temps égale aussi $\Delta$ T d'où la relation suivante faisant intervenir $\Delta$ T:

$$Q_S = \Delta T.Q'(T_1).... \qquad (2)$$

où $Q'(T_1)$ est la pente de la caractéristique au point (1).

L'efficacité de transfert s'exprime donc à l'aide des relations (1) et (2) en fonction du rapport des pentes de la caractéristique aux points (2) et (1):

$$\varepsilon = Q'(T_2)/Q'(T_1)$$

En conséquence si la charge d'entrainement $Q_0$ est suffisante pour atteindre la forte inversion, le terme $\varepsilon$ peut être de l'ordre de $10^{-3}$. Ainsi l'effet de rémanence se trouve considérablement réduit.

En conséquence, l'amplitude minimum de la charge d'entraîne ment $Q_0$ doit être telle qu'elle permette de passer en forte inversion au début du transfert des photodiodes vers les registres 2 même s'il n'y a pas de charge signal à transférer.

Toutefois, puisque la capacité des photodiodes est faible, la quantité de charges $Q_0$ peut être relativement petite. De manière spécifique, la quantité de charges $Q_0$ peut être choisie pour être comprise entre $\frac{QS\,max}{30}$ et $\frac{QS\,max}{10}$.

Il est évident pour l'homme de l'art que le dispositif de la figure 4 représente un mode de réalisation de l'injection des charges d'entrainement $Q_0$ conformément au procédé de la présente invention mais que cette injection peut être réalisée à l'aide de dispositif différent de celui de la figure 4.

Ainsi avec le procédé de la présente invention, on peut assurer un transfert efficace des charges des photodiodes vers les registres CCD 2 en réduisant au maximum le phénomène de rémanence.

## Revendications

1. Un procédé d'analyse d'un dispositif photosensible à structure interligne, ce dispositif comportant une matrice photosensible (1) de N colonnes de M points photosensibles (P), chaque point photosensible d'une même colonne étant connecté à un étage d'un registre à décalage (2) à transfert de charge qui assure le transfert des charges des points photosensibles (P) vers un registre de lecture (3) perpendiculaire aux registres à décalage (2), caractérisé en ce que le transfert des charges-signal ($Q_S$) des points photosensibles (P) vers les étages correspondants des registres à décalage (2) est réalisé en superposant aux charges-signal au niveau des points photosensibles une charge d'entrainement ($Q_0$) au moins suffisante pour permettre de passer en forte inversion au début du transfert.

2. Un procédé d'analyse selon la revendication 1, caractérisé en ce qu'il comporte les étapes suivantes:

1) injection dans chaque étage des registres à décalage (2), pendant le temps de lecture de la trame précédente, de la charge d'entraînement ($Q_0$),

2) transfert de la charge d'entraînement ($Q_0$) des registres à décalage (2) vers les points photosensibles (P) où elle se superpose aux charges-signal ($Q_S$),

3) transfert de l'ensemble charge signal-charge d'entraînement ($Q_0 + Q_S$) des points photosensibles (P) vers les registres à décalage (2) pour être lu selon le procédé usuel.

3. Un procédé selon l'une quelconque des revendications 1 à 2, caractérisé en ce que la charge d'entraînement ($Q_0$) a une valeur inférieure à $\frac{QS\,max}{10}$ dans laquelle $Q_S$ max correspond à la valeur maximale des charges-signal.

4. Un dispositif photosensible du type interligne pour la mise en oeuvre du procédé selon l'une quelconque des revendications 1 à 3, caractérisé en ce qu'il comporte de plus un

moyen pour injecter la charge d'entraînement ($Q_0$) dans les registres à décalage (2) et des moyens pour transférer la charge d'entraînement ($Q_0$) des registres (2) vers les photodiodes (P) à la fin du temps d'intégration.

5. Un dispositif selon la revendication 4, caractérisé en ce que le moyen pour injecter la charge d'entraînement ($Q_0$) dans les registres à décalage (2) est constitué par un registre à décalage analogique à entrée série et sorties parallèles, dont chaque sortie est connectée à l'entrée d'un registre à décalage (2) par l'intermediaire d'une grille de passage $G''_P$.

6. Un dispositif selon la revendication 4, caractérisé en ce que le moyen pour transférer la charge d'entrainement ($Q_0$) d'un registre (2) vers les photodiodes correspondantes (P) est constitué par une grille de passage ($G''_P$) portée à un niveau haut pendant le temps de transfert des charges du registre (2) vers les photodiodes (P) et vice- versa.

**Patentansprüche**

1. Verfahren zur Analyse einer lichtempfindlichen Vorrichtung mit Zwischenzeilenstruktur, wobei die Vorrichtung eine lichtempfindliche Matrix (1) mit N Spalten zu M lichtempfindlichen Punkten (P) besitzt und jeder lichtempfindliche Punkt einer gleichen Spalte mit einer Stufe eines Ladungstransfer-Schieberegisters (2) verbunden ist, das die Überführung der Ladungen der lichtempfindlichen Punkte (P) in ein Leseregister (2) senkrecht zu den Schieberegistern (2) bewirkt, dadurch gekennzeichnet, daß der Transfer der Signalladungen ($Q_S$) der lichtempfindlichen Punkte (P) in die entsprechenden Stufen der Schieberegister (2) dadurch bewirkt wird, daß den Signalladungen eine Treiberladung ($Q_0$) überlagert wird, die mindestens ausreicht, um zu Beginn des Transfers in den Bereich starker Inversion zu gelangen.

2. Analyseverfahren nach Anspruch 1, dadurch gekennzeichnet, daßes die folgenden Stufen umfaßt:

1) Die Treiberladung ($Q_0$) wird in jede Stufe der Schieberegister (2) während der Zeit des Lesens des voraufgehenden Rahmens eingespeist;

2) die Treiberladung ($Q_0$) wird von den Schieberegistern (2) zu den lichtempfindlichen Punkten (P) übertragen, wo sie sich den Signalladungen ($Q_S$) überlagert;

3) die Gesamtheit aus Signalladung und Treiberladung ($Q_0 + Q_S$) wird von den lichtempfindlichen Punkten (P) zu den Schieberegistern (2) übertragen, wo sie nach dem herkömmlichen Verfahren gelesen werden.

3. Verfahren nach einem beliebigen der Ansprüche 1 bis 2, dadurch gekennzeichnet, daß die Treiberladung ($Q_0$) einen Wert kleiner als $Q_S max/10$ besitzt, wobei $Q_S max$ dem Maximalwert der Signalladungen entspricht.

4. Lichtempfindliche Vorrichtung mit Zwischenzeilenstruktur zur Durchführung des Verfahrens nach einem beliebigen der Ansprüche 1 bis 3, dadurch gekennzeichnet, daß sie weiter ein Mittel zum Einspeisen der Treiberladung ($Q_0$) in die Schieberegister (2) und Mittel zur Überführung der Treiberladung ($Q_0$) von den Registern (2) in die Photodioden (P) am Ende der Integrationszeit besitzt.

5. Vorrichtung nach Anspruch 4, dadurch gekennzeichnet, daß das Mittel zum Einspeisen der Treiberladung ($Q_0$) in die Schieberegister (2) aus einem Analog-Schieberegister mit Serieneingang und Parallelausgängen besteht, wobei jeder Ausgang über ein Durchlaufgitter $G''_P$ mit dem Eingang eines Schieberegisters (2) verbunden ist.

6. Vorrichtung nach Anspruch 4, dadurch gekennzeichnet, daß das Mittel zur Überführung der Treiberladung ($Q_0$) von einem Register (2) zu den entsprechenden Photodioden (P) aus einem Durchlaufgitter ($G''_P$) besteht, das während der Überführungszeit der Ladungen von den Registern (2) in die Photodioden (P) und umgekehrt auf ein hohes Niveau gebracht wird.

**Claims**

1. A method for scanning a photosensitive device with an interline structure, comprising a photosensitive matrix (1) having N columns each of M photosensitive points (P), each photosensitive point of a same column being connected to a stage of a charge transfer shift register (2), which ensures the transfer of the charges from the photosensitive points (P) to a read-register (3) disposed perpendicularly to the shift registers (2), characterized in that the transfer of the signal charges ($Q_S$) of the photosensitive points (P) to the corresponding stages of the shift registers (2) is performed by superimposing, upon the signal charges in the photosensitive points, a driver charge ($Q_0$), which is at least sufficient for reaching strong inversion at the beginning of the transfer.

2. A scanning method according to claim 1, characterized in that it includes the following steps:

1) injection of the driver charge ($Q_0$) into each stage of the shift registers (2) during the read time of the preceding frame,

2) transfer of the driver charge ($Q_0$) from the shift registers (2) to the photosensitive points (P), where it is superimposed on the signal charge ($Q_S$),

3) transfer of the total of the signal charge and the driver charge ($Q_0 + Q_S$) from the photosensitive points (P) to the shift registers (2) for being read according to the known method.

3. A method according to any of claims 1 and 2, characterized in that the driver charge has a value inferior to $Q_S max/10$, wherein $Q_S max$

corresponds to a maximum value of the signal charges.

4. A photosensitive device of the interline type for implementing the method according to any one of claims 1 to 3, characterized in that it comprises in addition a means for injecting the driver charge ($Q_0$) into the shift registers (2), and means for transferring the driver charge ($Q_0$) from the registers (2) to the photodiodes (P) at the end of the integration period.

5. A device according to claim 4, characterized in that the means for injecting the driver charge ($Q_0$) into the shift registers (2) is constituted by an analog shift register having a series input and parallel outputs, of which each output is connected to the input of a shift register (2) via a passage grid $G''_P$.

6. A device according to claim 4, characterized in that the means for transferring the driver charge ($Q_0$) from a register (2) to the corresponding photodiodes (P) is constituted by a passage grid ($G''_P$), put to a high level during the time of transfer of the charges from the register (2) to the photodiodes (P), and vice-versa.

FIG_1

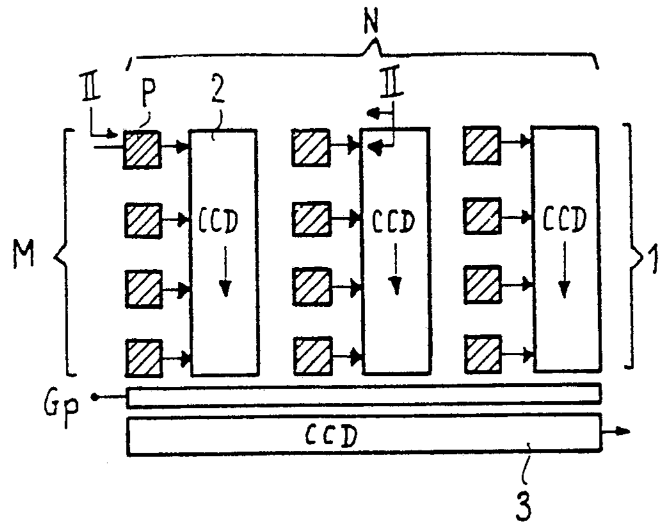


FIG_2

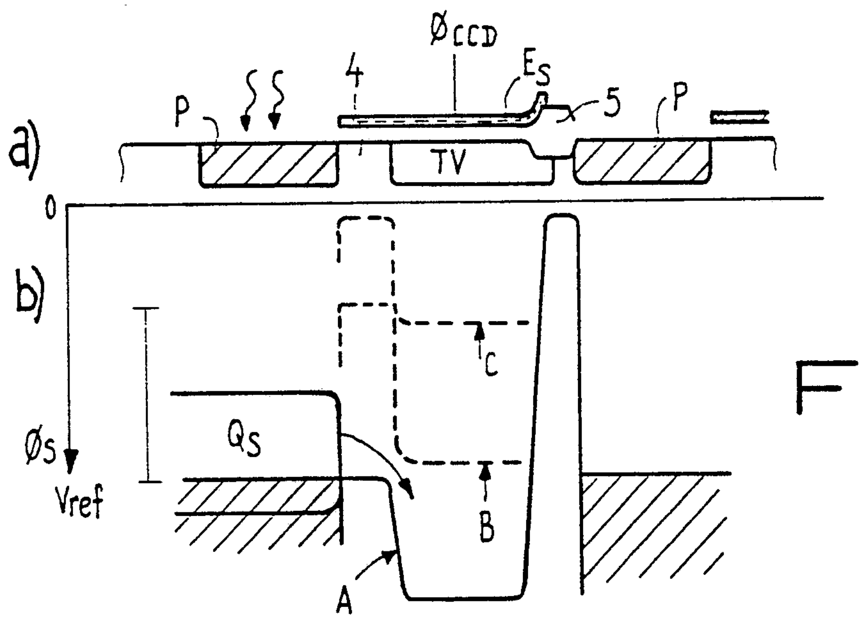


FIG_3

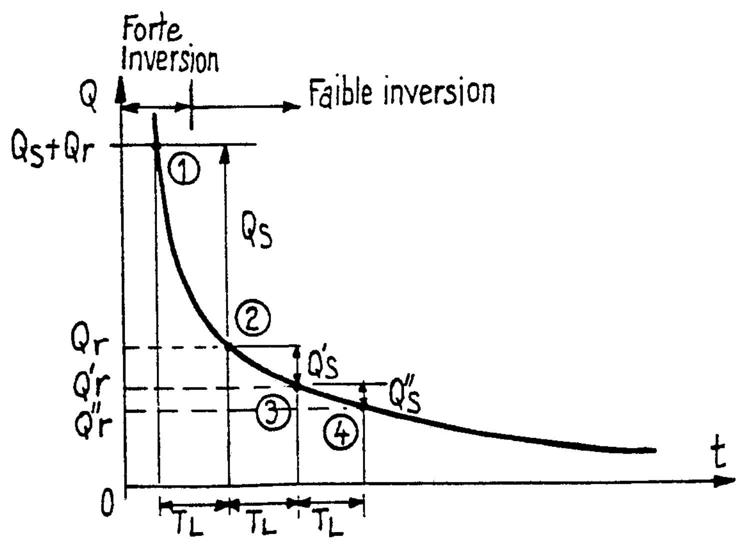

FIG_4

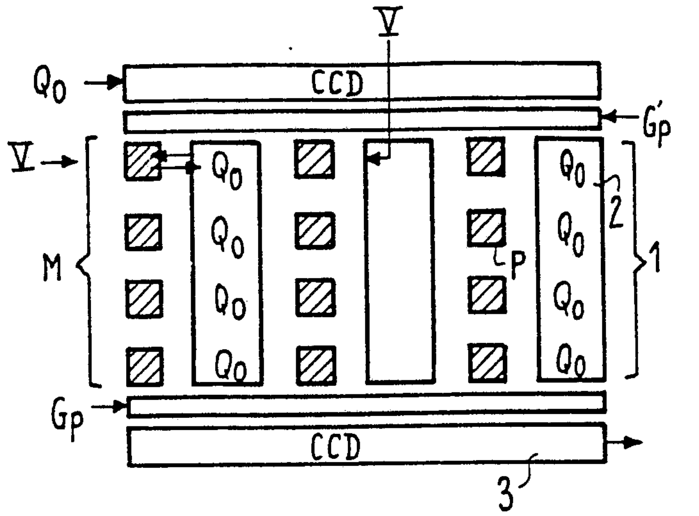


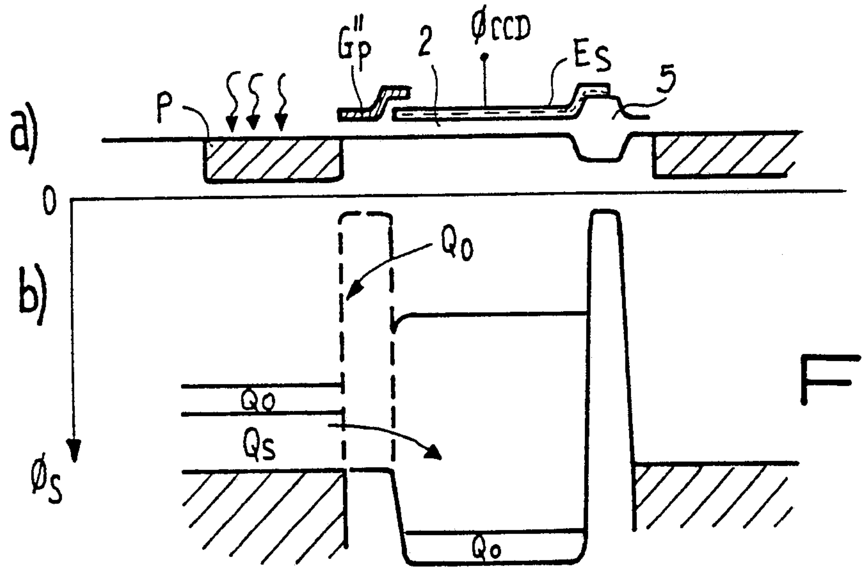


FIG_5

FIG_6